Europäisches Patentamt

(19) European Patent Office

Office européen des brevets

(11) Numéro de publication : **0 147 259**
**B1**

(12) **FASCICULE DE BREVET EUROPÉEN**

(45) Date de publication du fascicule du brevet :
01.02.89

(21) Numéro de dépôt : **84402215.2**

(22) Date de dépôt : **05.11.84**

(51) Int. Cl.⁴ : **G 03 B 39/00**, G 03 B 17/24,
H 01 S 3/10

(54) **Marqueur à diode-laser pour cinématographie ultra-rapide.**

(30) Priorité : **09.11.83 FR 8317812**

(43) Date de publication de la demande :
**03.07.85 Bulletin 85/27**

(45) Mention de la délivrance du brevet :
**01.02.89 Bulletin 89/05**

(84) Etats contractants désignés :
**DE GB NL**

(56) Documents cités :
**DE—A— 2 820 908**
**US—A— 3 603 974**
**US—A— 3 858 063**
**US—A— 4 400 812**
**PROCEEDINGS OF THE NINTH INTERNATIONAL CONGRESS ON HIGH SPEED PHOTOGRAPHY, Denver, Colorado, 2-7 août 1970, pages 68-74, SMPTE, New York, US; F. CHABANNES et al.: "Application of phase-locked solid lasers to high-speed cinematography"**
**FEINWERKTECHNIK & MESSTECHNIK, vol. 89, no. 5, juillet/août 1981, pages 225-228, Munich, DE; M. FABIAN: "Pulsschaltungen für Laserdioden"**

(73) Titulaire : **COMMISSARIAT A L'ENERGIE ATOMIQUE 31/33, rue de la Fédération F-75015 Paris (FR)**

(72) Inventeur : **Gidon, Serge Rue des Edelweiss F-38500 Voiron (FR)**

(74) Mandataire : **Mongrédien, André et al c/o BREVATOME 25, rue de Ponthieu F-75008 Paris (FR)**

## Description

La présente invention concerne un marqueur à diode-laser pour cinématographie ultra-rapide Elle s'applique notamment au repérage temporel d'événements.

On sait que la cinématographie ultra-rapide est une technique consistant à filmer, à l'aide d'une caméra appropriée, un événement dont la durée est très courte et peut être de l'ordre de quelques dizaines de microsecondes, voire moins.

Pour étudier un tel événement, après l'enregistrement de celui-ci sur un support photosensible ou film dont on a muni la caméra, on est amené à repérer un ou plusieurs instants particuliers, synchrones à l'événement, par exemple des instants séparés les uns des autres par un même intervalle de temps, en marquant le support photosensible au moyen de signaux lumineux synchrones à ces instants particuliers.

Pour ce faire, on peut utiliser un dispositif appelé « marqueur », comprenant une diode électroluminescente dont le rayonnement émis se situe dans le proche infrarouge, en association avec une caméra électronique à tube équipé d'une photocathode de type S 20 ou S 20R.

Un tel marqueur présente l'inconvénient de conduire à des enregistrements pâles, voire inutilisables, compte tenu de la faible radiance de la source lumineuse utilisée et du fait que la photocathode employée n'est que peu sensible au proche infrarouge.

La présente invention a pour but de remédier notamment à cet inconvénient.

On connaît par le document US-A-3603974 un dispositif utilisant une diode électroluminescente et permettant le marquage d'un film utilisé dans une caméra cinématographique ultrarapide.

On connaît également par le document US-A-3858063 un marqueur pour caméra cinématographique classique, qui comporte une diode électroluminescente pour marquer le film présent dans la caméra.

On connaît en outre par le document « Electronik 1975 », Heft 6 pp. 87-94, l'existence de diodes-lasers à fonctionnement par impulsions.

L'invention a pour objet un marqueur pour caméra cinématographique ultra-rapide, comprenant :

- au moins une source lumineuse à fonctionnement par impulsions, et
- des moyens électroniques de commande de chaque source, permettant à celle-ci d'émettre un signal lumineux, marqueur caractérisé en ce qu'il comprend en outre des moyens de transmission de ce signal lumineux à une surface photosensible dont est munie la caméra, en ce que la source à fonctionnement par impulsions est une diode-laser de puissance, et en ce que les moyens électroniques de commande comprennent des moyens de production d'un nombre déterminé d'impulsions électriques de forte intensité, dont la somme des durées est au plus égale à la durée maximale d'une impulsion lumineuse que la diode-laser est capable d'émettre.

Le marqueur objet de l'invention permet de réaliser des enregistrements bien plus contrastés que ceux qui sont obtenus avec le marqueur connu décrit précédemment, du fait qu'il utilise une diode-laser dont la radiance est très supérieure à celle d'une diode électroluminescente et qui est donc bien mieux adaptée à la cinématographie ultra-rapide, technique qui nécessite une puissance lumineuse importante étant donné la rapidité des événements étudiés.

Une telle diode-laser est en outre nettement plus puissante que les diodes électroluminescentes et les diodes-lasers continues qui sont seulement capables de délivrer une puissance lumineuse de l'ordre de quelques milliwatts alors qu'une diode-laser de puissance à fonctionnement par impulsions peut émettre plusieurs watts. Certes, cette émission a lieu pendant un très court instant (environ quelques centaines de nanosecondes) comparativement aux diodes électroluminescentes et aux diodes-lasers classiques dont l'émission peut être continue, mais ceci n'est pas gênant compte tenu de la faible durée des événements filmés par cinématographie ultra-rapide.

La durée maximale d'une impulsion lumineuse qu'une diode-laser de puissance à fonctionnement par impulsions est capable d'émettre reste compatible avec la durée des événements étudiés par cinématographie ultra-rapide. En effet, une utilisation classique d'une diode-laser de puissance à fonctionnement par impulsions, dans des domaines autres que la cinématographie ultra-rapide, réside dans la production d'une impulsion lumineuse, de l'ordre de quelques centaines de nanosecondes avec une telle diode, puis éventuellement d'autres impulsions lumineuses identiques en attendant suffisamment entre les impulsions pour ne pas détériorer la diode. Cependant, dans la présente invention, compte tenu de l'extrême rapidité de la plupart des événements étudiés par cinématographie ultra-rapide, on utilise de façon originale la diode-laser de puissance « en multi-impulsions » c'est-à-dire en associant la diode-laser à des moyens de commande permettant d'obtenir une pluralité d'impulsions lumineuses dont la somme des durées est au plus égale à l'impulsion unique classiquement obtenue, de façon à ne pas détériorer la diode. Tout se passe comme si on subdivisait une impulsion lumineuse unique en une pluralité d'impulsions lumineuses successives convenablement espacées. On peut ainsi « couvrir » la totalité d'un phénomène étudié dont la durée est par exemple de l'ordre de 10 microsecondes. En outre, on dispose ainsi d'un marqueur non seulement intense mais encore très précis.

La diode-laser de puissance utilisée est par exemple une diode-laser de puissance à simple hétérostructure.

La caméra est par exemple une caméra électronique qui est munie d'une fente pour délimiter le champ optique de la caméra et qui comporte une surface photosensible exposée au champ délimité par la fente.

Dans ce cas, selon une réalisation particulière de l'invention, la diode-laser est placée dans le champ délimité par la fente, en bordure de ce champ, et les moyens de transmission comportent une optique de focalisation du signal lumineux à travers la fente, sur la surface photosensible.

Dans ce cas également, selon une autre réalisation particulière, les moyens de transmission comportent une fibre optique dont une extrémité est optiquement couplée à la diode-laser et dont l'autre extrémité est optiquement couplée à la surface photosensible, en bordure du champ délimité par la fente.

On peut par exemple utiliser une caméra électronique à fente, sensible dans l'ultraviolet, la diode-laser étant alors une diode-laser émettant dans l'ultraviolet.

La caméra peut également être une caméra mécano-optique munie d'une fente pour délimiter le champ optique de la caméra, la diode-laser étant alors choisie de façon à émettre de la lumière appartenant à la région visible du spectre électromagnétique.

Avec cet autre type de caméra, comportant un miroir tournant apte à réfléchir l'image du champ délimité par la fente sur un support photosensible ou film constituant dans ce cas ladite surface photosensible, la diode-laser peut être placée dans ce champ, en bordure de celui-ci, les moyens de transmission comportant alors une optique de focalisation du signal lumineux sur le support photosensible par l'intermédiaire du miroir tournant.

La caméra étant destinée à filmer un événement, les moyens électroniques de commande peuvent comprendre :

- des moyens de synchronisation du fonctionnement de La diode-laser avec le début de l'événement,
- un générateur d'impulsions électriques,
- un compteur d'impulsions commandé par les moyens de synchronisation, asservi par le générateur d'impulsions et commandant celui-ci, de manière que le générateur d'impulsions produise un nombre déterminé d'impulsions dont la somme des durées soit au plus égale à la durée maximale d'une impulsion lumineuse que la diode-laser est capable d'émettre, puis s'arrête une fois ce nombre produit, et
- un amplificateur de puissance, pour amplifier les impulsions issues du générateur d'impulsions, les impulsions amplifiées étant alors transmises à la diode-laser.

Selon un autre mode de réalisation particulier, la caméra étant destinée à filmer un événement, les moyens électroniques de commande peuvent comprendre :

- des moyens de synchronisation du fonctionnement de la diode-laser avec le début de l'événement,
- au moins un générateur d'impulsion électrique monostable réglable, chaque générateur monostable ayant son entrée reliée aux moyens de synchronisation et étant réglé de manière à émettre à un moment déterminé, après le début de l'événement, une impulsion électrique de durée appropriée et de manière que la somme des durées des impulsions émises par les générateurs monostables soit au plus égale à la durée maximale d'une impulsion lumineuse que la diode-laser est capable d'émettre, et

- un amplificateur de puissance dont l'entrée est reliée à la sortie de chaque générateur monostable et dont la sortie est reliée à la diode-laser.

Enfin, dans un mode de réalisation préféré, l'amplificateur de puissance comprend des transistors de puissance du type HMOS ou VMOS, pour amplifier les impulsions électriques reçues à son entrée.

Cet amplificateur de puissance peut comprendre successivement un étage de gain adaptateur d'impédance, un étage abaisseur d'impédance en source suiveuse et un étage fournisseur de gain en courant, les deux derniers étages étant réalisés à l'aide desdits transistors de puissance.

L'invention sera mieux comprise à la lecture de la description qui suit, d'exemples de réalisation donnés à titre indicatif et nullement limitatif, en référence aux figures annexées sur lesquelles :

- la figure 1 est une vue schématique d'un enregistrement cinématographique ultra-rapide d'un événement, comportant des marquages effectués par l'invention,
- les figures 2 et 3 sont des vues schématiques de modes de réalisation particuliers du marqueur objet de l'invention, dans le cas où celui-ci est utilisé avec une caméra électronique à fente,
- la figure 4 est une vue schématique d'un autre mode de réalisation particulier du marqueur objet de l'invention, dans le cas où celui-ci est utilisé avec une caméra mécano-optique,
- la figure 5 est une vue schématique d'un mode de réalisation particulier des moyens électroniques de commande d'un marqueur selon l'invention,
- la figure 6 est une vue schématique d'un mode de réalisation particulier d'un amplificateur de puissance dont sont munis ces moyens électroniques de commande, et
- la figure 7 est une vue schématique d'un autre mode de réalisation particulier des moyens électroniques de commande.

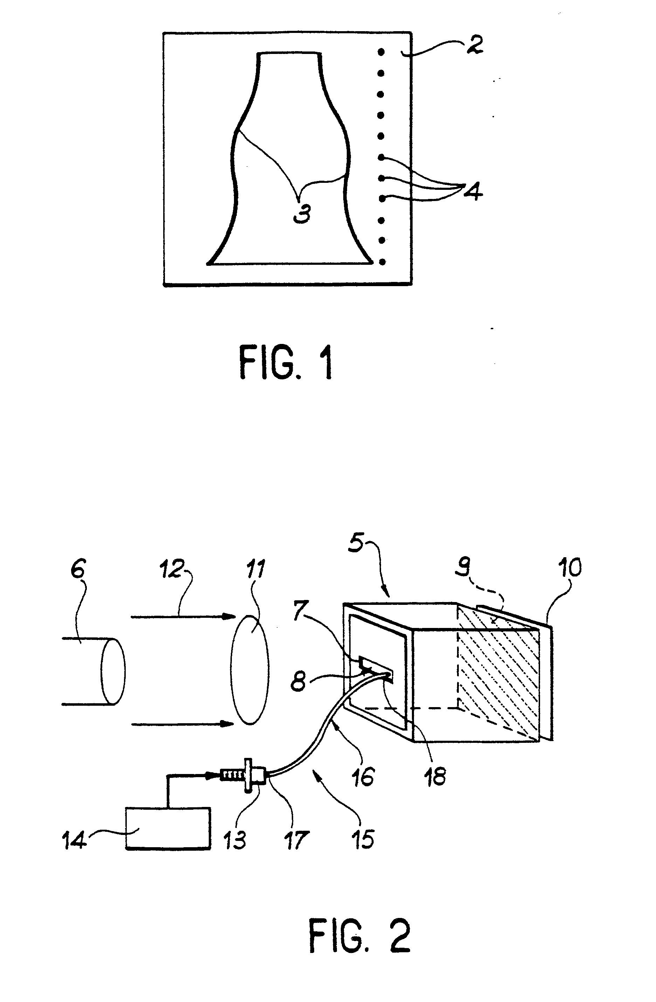

Sur la figure 1, on a représenté schématiquement un enregistrement 2 d'un événement, obtenu à l'aide d'une caméra cinématographique ultra-rapide. Par « événement », on entend la déformation ou le mouvement d'un objet, par exemple le mouvement d'une balle en train de perforer une paroi, ou plus généralement tout phénomène physique visible tel que la foudre par exemple. Sur la figure 1, l'événement consiste par exemple en une brutale déformation radiale d'un cylindre observé par la tranche, à l'aide d'une caméra à fente visant un diamètre du cylindre, ce qui conduit a un enregistrement 2 comportant une surface limitée par deux lignes 3. L'invention permet de marquer cet enregistrement à l'aide de points 4 régulièrement espacés et alignés en regard d'une ligne 3, de préférence en bordure de l'enregistrement 2. L'invention permettrait également de marquer un enregistrement cinématographique ultra-rapide d'un événement à l'aide d'un ou plusieurs points correspondant à des moments intéressants de l'événement étudié. Bien entendu, le marqueur objet de l'invention n'est pas limité à un emploi avec une caméra à fente mais peut être utilisé avec toute caméra cinématographique ultra-rapide.

Sur la figure 2, on a représenté schématiquement un mode de réalisation particulier du marqueur objet de l'invention, utilisé avec une caméra électronique à fente 5 destinée à filmer un événement tel que la déformation d'un objet 6. La caméra 5 comporte de façon connue une fente 7 qui délimite le champ de la caméra, une surface photosensible constituée par une photocathode 8 qui est exposée au champ délimité par la fente 7 et un écran luminescent 9 en regard duquel est disposé un film 10 pour obtenir un enregistrement de l'événement étudié. La caméra 5 comporte également un objectif 11 qui est situé devant la fente 7 et qui permet de former l'image de l'objet 6 sur la photocathode 8, à travers la fente 7. Sur la figure 2, l'objet 6 est représenté à proximité de l'objectif 11, à cause de la taille limitée de la figure 2. En pratique, l'objet 6 est beaucoup plus éloigné de l'objectif 11. C'est pourquoi les rayons lumineux 12 issus de l'objet 6 sont représentés par des droites parallèles.

La caméra 5 est par exemple une caméra commercialisée par la société THOMSON sous la référence TSN et munie d'une photocathode de type S 20 ou S 20R.

Le marqueur selon l'invention comporte une diode-laser de puissance à fonctionnement par impulsions 13, des moyens électroniques 14 pour commander cette diode et des moyens 15 de transmission à la photocathode 8, des signaux lumineux que la diode-laser est capable d'émettre. Dans le mode de réalisation particulier représenté sur la figure 2, ces moyens 15 de transmission comprennent une fibre optique 16 dont une extrémité 17 est optiquement couplée à la diode-laser 13 et dont l'autre extrémité 18 est optiquement couplée à la cathode 8, en bordure du champ délimité par la fente 7. L'autre extrémité 18 de la fibre optique 16 est par exemple fixée en regard de la photocathode 8, a une extrémité de la fente 8.

La diode-laser 13 consiste par exemple en une diode-laser à simple hétérojonction commercialisée par la société RCA sous la référence SG 2002A dont la puissance crête est de l'ordre de 9 W à 904 nm pendant une durée maximale de 200 ns.

Sur la figure 3, on a représenté schématiquement un autre mode de réalisation particulier du marqueur objet de l'invention, comprenant la diode-laser 13 associée aux moyens électroniques de commande 14 et coopérant encore avec la caméra électronique à fente 5. Dans cet autre mode de réalisation particulier, la diode-laser 13 est placée dans le champ délimité par la fente 7, en bordure de ce champ et les moyens de transmission 15 sont constitués par une optique 19 telle qu'une lentille convergente, appelée « lentille de transport d'image » et disposée sur l'axe optique Z de l'objectif 11 de la caméra, entre cet objectif 11 et la fente 7, de manière que les rayons lumineux 12 issus de l'objet 6 soient focalisés en un point F par l'objectif 11 puis envoyés sur la photocathode 8 par l'intermédiaire de la lentille de transport d'image 19. La diode-laser 13 est disposée entre cette dernière et l'objectif 11, la face émissive de la diode-laser 13 étant située dans un plan passant par le point F et perpendiculaire à l'axe Z, de telle façon qu'un signal lumineux émis par la diode-laser soit focalisé sur un bord de la photocathode 8 par l'intermédiaire de la lentille de transport d'image 19.

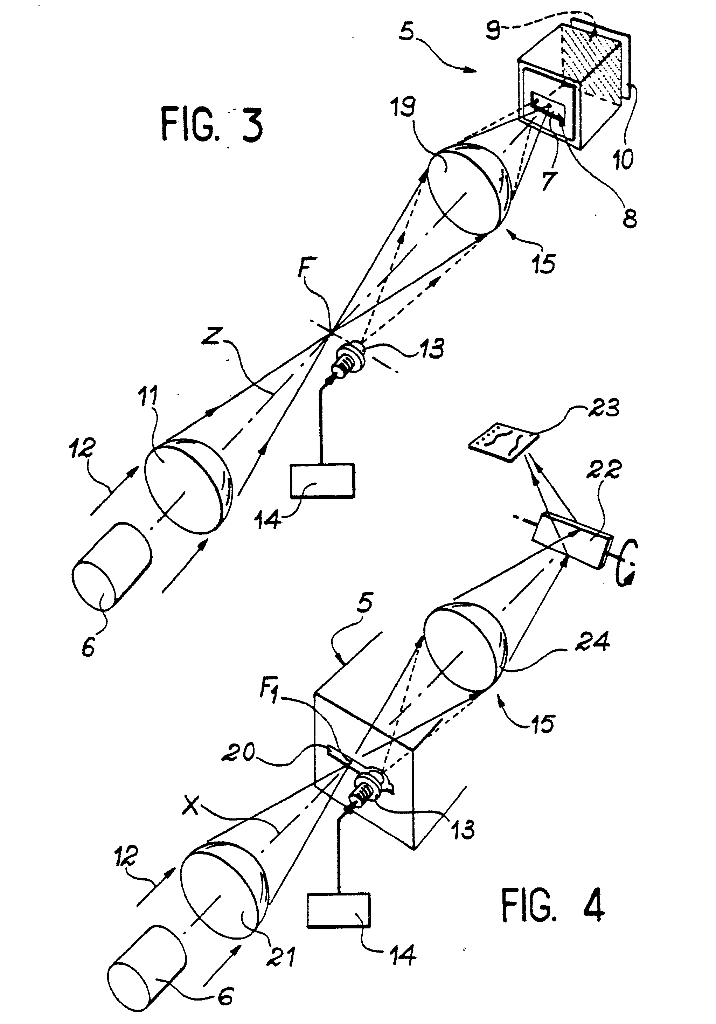

Sur la figure 4, on a représenté schématiquement un autre mode de réalisation particulier du marqueur objet de l'invention, comprenant la diode-laser 13 associée aux moyens électroniques de commande 14 et coopérant avec une caméra cinématographique ultra-rapide de type mécano-optique, comportant une fente 20 pour délimiter le champ optique de la caméra, un objectif 21 situé devant la fente 20 et un miroir tournant 22 apte à réfléchir l'image du champ délimité par la fente sur un support photo-sensible ou film 23.

Les moyens de transmission 15 comportent une optique de focalisation 24 telle qu'une lentille convergente, située sur l'axe optique x de l'objectif 21, entre la fente 20 et le miroir tournant 22. Les dispositions respectives de l'objectif 21 et de la lentille 24 sont telles que les rayons lumineux 12 issus du phénomène étudié, par exemple de l'objet 6 en train de se déformer, soient focalisés en un point $F_1$ de la fente 20 puis envoyés à partir de ce point $F_1$ sur le film 23 par l'intermédiaire de la lentille 24 puis du miroir tournant 22.

Dans le mode de réalisation particulier représenté sur la figure 4, la diode-laser 13 est choisie de façon à émettre de la lumière appartenant à la région visible du spectre électromagnétique. La diode-laser 13 est d'autre part placée dans le champ optique délimité par la fente 20, en bordure de celui-ci. Pour ce faire, la diode-laser 13 est fixée sur un bord de la fente 20 de façon que les signaux lumineux qu'elle est susceptible d'émettre soient focalisés sur un bord du film 23 par l'intermédiaire de la lentille 24 et du miroir tournant 22.

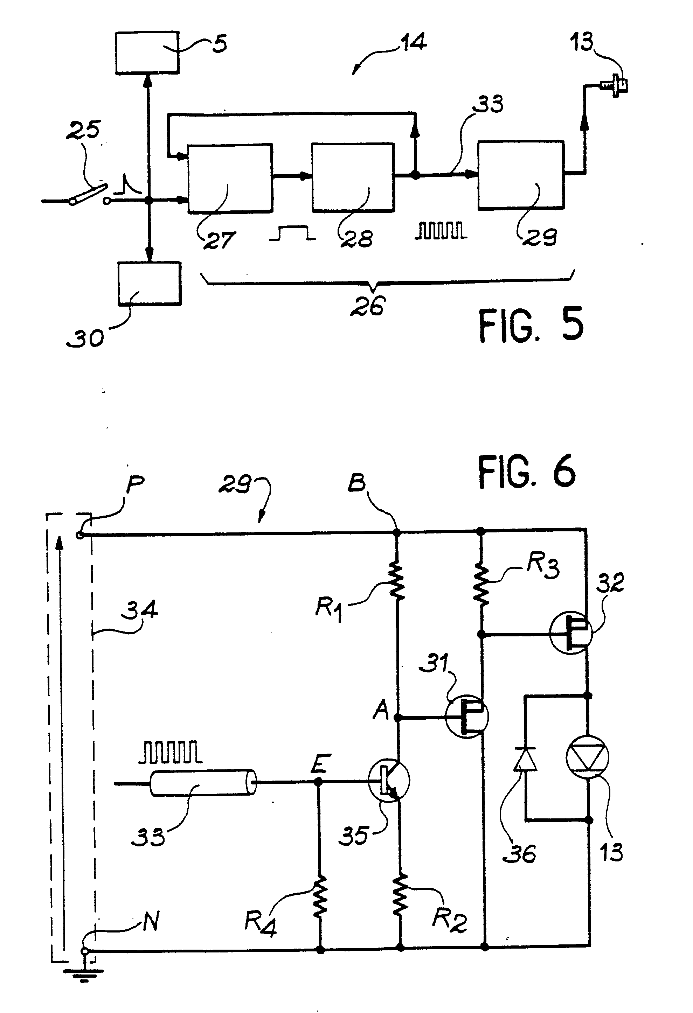

Sur la figure 5, on a représenté schématiquement un mode de réalisation particulier des moyens électroniques de commande 14, dans le cas où l'on utilise une diode-laser de puissance à fonctionnement par impulsions. Il comprend des moyens 25 de synchronisation du fonctionnement de la diode-laser 13 avec le début de l'événement étudié et avec le fonctionnement de la caméra 5, ainsi que des moyens 26 de production d'un nombre déterminé d'impulsions électriques de forte intensité, dont la somme des durées est au plus égale à la durée maximale d'une impulsion lumineuse que la diode-laser est capable d'émettre.

Ces moyens 26 de production comprennent un compteur d'impulsions 27, un générateur d'impulsions électriques 28 et un amplificateur de puissance 29.

Le compteur 27 comporte des moyens de remise à zéro qui sont reliés aux moyens de synchronisation 25. La sortie du compteur 27 est reliée à l'entrée du générateur d'impulsion électrique 28 dont la sortie est reliée à l'entrée de l'amplificateur de puissance 29. La sortie de celui-ci est reliée à la diode-laser 13. En outre, la sortie du générateur d'impulsions électriques 28 est reliée à une entrée du compteur 27, de sorte que celui-ci est asservi par le générateur d'impulsions électriques 28.

Les moyens de synchronisation 25 peuvent se concevoir comme une sorte d'interrupteur qui commande à la fois le fonctionnement de la diode-laser, le fonctionnement de la caméra et des moyens 30 permettant de faire débuter l'événement à étudier. Par exemple, dans le cas de la déformation d'un objet, ces moyens 30 peuvent consister en un détonateur dont l'explosion provoque cette déformation.

Le fonctionnement des moyens électroniques de commande 14 est le suivant : les moyens de synchronisation 25 déclenchent le compteur 27 qui déclenche a son tour le générateur 28. Le générateur 28 délivre ainsi des impulsions électriques dont l'intensité est amplifiée par l'amplificateur de puissance 29 de manière à obtenir des impulsions dont l'intensité est élevée, par exemple de l'ordre de 10 ampères, pour pouvoir alimenter la diode-laser de puissance. Les impulsions électriques émises par le générateur 28 sont comptabilisées par le compteur 27. Lorsqu'un nombre déterminé d'impulsions est obtenu, le compteur 27 commande l'arrêt du générateur 28 (par l'intermédiaire d'une porte logique faisant partie du générateur, la sortie du compteur étant reliée à cette porte logique). Le générateur 28 comporte des moyens pour régler le temps séparant deux impulsions électriques qu'il est susceptible d'émettre et pour régler la durée de ces impulsions.

Le nombre déterminé d'impulsions est tel que la somme des durées de celles-ci soit au plus égale à la durée maximale d'une impulsion lumineuse que la diode-laser est capable d'émettre. Le compteur 27 est réglé pour compter jusqu'à ce nombre déterminé.

Par exemple, la diode-laser commercialisée par la société RCA sous la référence SG 2002A est capable d'émettre des impulsions de 200 ns. Les moyens électroniques de commande 14 permettent pour ainsi dire de subdiviser une telle impulsion de 200 ns en N impulsions de 200/N ns. Le nombre N étant par exemple égal à 20, on peut régler le générateur 28 de façon à séparer chacune des 20 impulsions de la suivante par un intervalle de temps déterminé, égal à 1 µs par exemple, de manière à obtenir un marquage régulier pour un événement qui dure environ 20 µs.

Sur la figure 6, on a représenté schématiquement un mode de réalisation particulier de l'amplificateur de puissance 29. Celui-ci est réalisé à l'aide de deux transistors de puissance 31 et 32 du type HMOS. L'entrée E de l'amplificateur de puissance est reliée à la sortie du générateur d'impulsions électriques 28 par un câble coaxial 33. En outre, l'amplificateur de puissance 29 est alimenté par une source 34 de courant continu dont le pôle négatif N est mis à la masse.

L'amplificateur de puissance 29 comprend d'abord un étage de gain adaptateur d'impédance réalisé à l'aide d'un transistor 35 de type NPN. La base de ce transistor est reliée à l'entrée E. Elle est également reliée à la masse par l'intermédiaire d'une résistance électrique $R_4$. Le collecteur dudit transistor est relié à une extrémité A d'une résistance électrique $R_1$, l'autre extrémité B de cette résistance $R_1$ étant reliée au pôle positif P de la source 34. Enfin, l'émetteur du transistor 35 est relié à la masse par l'intermédiaire d'une résistance électrique $R_2$.

L'amplificateur de puissance 29 comprend ensuite un étage fonctionnant en abaisseur d'impédance en source suiveuse, réalisé à l'aide du transistor de puissance 31. Celui-ci est relié par sa porte à l'extrémité A de la résistance $R_1$ et par son drain a la masse. La source du transistor de puissance 31 est reliée, par l'intermédiaire d'une résistance électrique $R_3$, au pôle positif P de la source 34.

L'amplificateur de puissance 29 comprend enfin un étage pour fournir le gain en courant, réalisé à l'aide de l'autre transistor de puissance 32 dont la porte est reliée à la liaison entre la source du transistor de puissance 31 et la résistance électrique $R_3$. En outre, cet autre transistor de puissance 32 est relié par son drain, à l'anode de la diode-laser 13, et par sa source, au pôle positif P de la source de courant 34.

La cathode de la diode-laser 13 est reliée la masse. Pour éviter les surtensions aux bornes de cette diode-laser, une diode de roue libre 36 est montée tête-bêche avec la diode-laser 13, entre les bornes de cette dernière.

A titre indicatif et nullement limitatif, les résistances électriques $R_1$, $R_2$, $R_3$ et $R_4$ ont respectivement pour valeurs 56 ohms, 5 ohms, 5 ohms, et 57 ohms, la tension aux bornes de la source 34 est de 15 V, le transistor 35 est du genre de celui qui est commercialisé par la Société RTC sous la référence 2N2219 A, la diode-laser de puissance est du genre de celle qui est commercialisée par la Société RCA sous la référence SG 2002A, la diode de roue libre est du genre de celle qui est commercialisée par la Société RTC sous la référence 1N4148 et les deux transistors de puissance 31 et 32 sont du genre de celui qui est commercialisé par la Société INTERNATIONAL RECTIFIER sous la référence IRF 9520. Au lieu de transistors HMOS, on pourrait utiliser des transistors du type DMOS pour réaliser l'amplificateur de puissance 29.

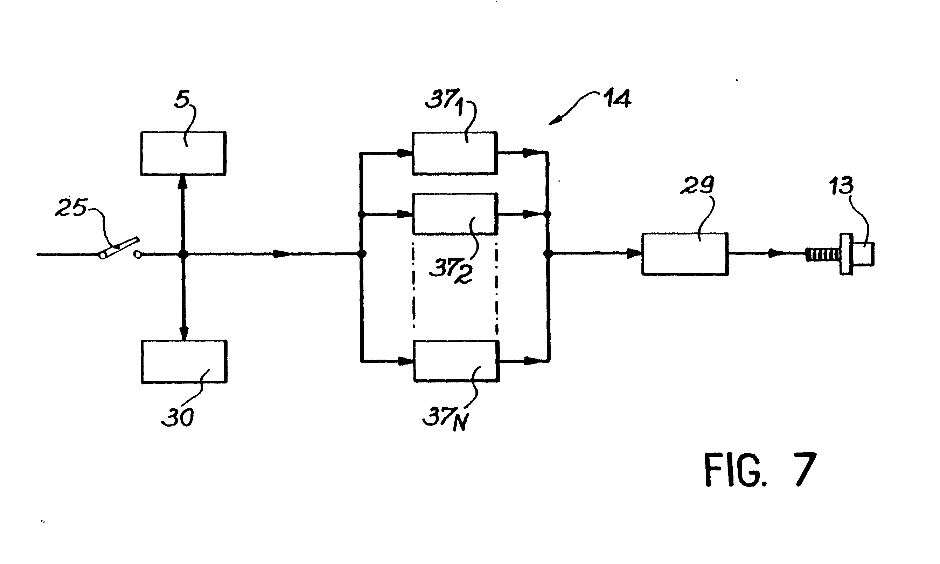

Sur la figure 7, on a représenté schématiquement un autre mode de réalisation particulier des moyens de commande 14 que l'on peut utiliser dans le cas où l'on souhaite simplement marquer un ou plusieurs instants précis de l'événement à l'aide de la diode-laser de puissance 13 à fonctionnement par impulsions. Outre les moyens 25 de synchronisation et l'amplificateur de puissance 29 mentionnés plus haut, cet autre mode de réalisation comprend un ou plusieurs générateurs monostables réglables $37_1$, $37_2$, ..., $37_N$ dont le nombre N est égal au nombre d'instants précis à marquer et qui sont aptes à engendrer chacun une unique impulsion électrique. L'entrée de chaque générateur monostable est reliée aux moyens 25 de synchronisation et la sortie de chacun de ces générateurs monostables est reliée a l'entrée E de l'amplificateur de puissance 29 dont la sortie est reliée à la diode-laser 13. Chaque générateur monostable est réglé d'une part de façon à produire, à un moment déterminé après le début de l'événement, une impulsion électrique de durée appropriée et d'autre part, de façon que la somme des durées des impulsions correspondant aux différents générateurs monostables soit au plus égale à la durée maximale d'une impulsion lumineuse que la diode-laser est capable d'émettre.

Par exemple, pour un événement qui dure 20 $\mu s$, on peut souhaiter marquer trois instants se produisant respectivement 1 $\mu s$, 5 $\mu s$ et 10 $\mu s$ après le début de l'événement. On utilise alors trois générateurs monostables que l'on règle pour produire chacun une impulsion de 20 ns, respectivement 1 $\mu s$, 5 $\mu s$ et 10 $\mu s$ après le début de l'événement.

## Revendications

1. Marqueur pour caméra cinématographie ultra-rapide, comprenant :

au moins une source lumineuse (13) à fonctionnement par impulsions, et

des moyens électroniques (14) de commande de chaque source, permettant à celle-ci d'émettre un signal lumineux, marqueur caractérisé en ce qu'il comprend en outre des moyens (15) de transmission de ce signal lumineux à une surface photosensible (8, 23) dont est munie la caméra (5), en ce que la source (13) à fonctionnement par impulsions est une diode-laser de puissance, et en ce que les moyens électroniques de commande (14) comprennent des moyens (26) de production d'un nombre déterminé d'impulsions électriques de forte intensité, dont la somme des durées est au plus égale à la durée maximale d'une impulsion lumineuse que la diode-laser (13) est capable d'émettre.

2. Marqueur selon la revendication 1, caractérisé en ce que, la caméra étant destinée à filmer un événement, les moyens électroniques de commande (14) comprennent :

des moyens (25) de synchronisation du fonctionnement de la diode-laser (13) avec le début de l'événement,

un générateur d'impulsions électriques (28),

un compteur d'impulsions (27) commandé par les moyens (25) de synchronisation, asservi par le générateur d'impulsions (28) et commandant celui-ci, de manière que le générateur d'impulsions produise un nombre déterminé d'impulsions dont la somme des durées soit au plus égale à la durée maximale d'une impulsion lumineuse que la diode-laser (13) est capable d'émettre, puis s'arrête une fois ce nombre produit, et

un amplificateur de puissance (29), pour amplifier les impulsions issues du générateur d'impulsions (28), les impulsions amplifiées étant alors transmises à la diode-laser (13).

3. Marqueur selon la revendication 1, caractérisé en ce que, la caméra étant destinée à filmer un événement, les moyens électroniques de commande (14) comprennent :

des moyens (25) de synchronisation du fonctionnement de la diode-laser (13) avec le début de l'événement,

au moins un générateur d'impulsion électrique monostable réglable ($37_1$, ... $37_N$), chaque générateur monostable ayant son entrée reliée aux moyens (25) de synchronisation et étant réglé de manière à émettre, à un moment déterminé après le début de l'événement, une impulsion électrique de durée appropriée, et de manière que la somme des durées des impulsions émises par les générateurs monostables soit au plus égale à la durée maximale d'une impulsion lumineuse que la diode-laser (13) est capable d'émettre, et

un amplificateur de puissance (29) dont l'entrée est reliée à la sortie de chaque générateur monostable et dont la sortie est reliée à la diode-laser (13).

4. Marqueur selon l'une quelconque des revendications 2 et 3, caractérisé en ce que l'amplificateur de puissance (29) comprend des transistors de puissance (31, 32) du type HMOS ou VMOS, pour amplifier les impulsions électriques reçues à son entrée.

5. Marqueur selon la revendication 4, caractérisé en ce que l'amplificateur de puissance (29) comprend successivement un étage de gain adaptateur d'impédance, un étage abaisseur d'impédance en source suiveuse et un étage fournisseur de gain en courant, les deux derniers étages étant réalisés à l'aide desdits transistors de puissance (31, 32).

6. Marqueur selon l'une quelconque des revendications 1 à 5, caractérisé en ce que la caméra (5) est une caméra électronique munie d'une fente (7) pour délimiter le champ optique de la caméra et comporte une surface photosensible (8) exposée au champ délimité par la fente.

7. Marqueur selon la revendication 6, caractérisé en ce que la diode-laser (13) est placée dans le champ délimité par la fente (7), en bordure de ce champ, et en ce que les moyens (15) de transmission comportent une optique (19) de focalisation du signal lumineux à travers la fente, sur la surface photosensible (8).

8. Marqueur selon la revendication 6, caractérisé en ce que les moyens (15) de transmission comportent une fibre optique (16) dont une extrémité (17) est optiquement couplée à la diode-laser (13) et dont l'autre extrémité (18) est optiquement couplée à la surface photosensible (8), en bordure du champ délimité par la fente (7).

9. Marqueur selon l'une quelconque des revendications 1 à 5, caractérisé en ce que la caméra (5) est une caméra mécano-optique munie d'une fente (20) pour délimiter le champ optique de la caméra et en ce que la diode-laser (13) est apte à émettre de la lumière appartenant à la région visible du spectre électromagnétique.

10. Marqueur selon la revendication 9, caractérisé en ce que la caméra (5) comporte un miroir tournant (22) apte à réfléchir l'image du champ délimité par la fente (20) sur un support photosensible (23), en ce que la diode-laser (13) est placée dans ce champ, en bordure de celui-ci et en ce que les moyens (15) de transmission comportent une optique (24) de focalisation du signal lumineux sur le support photosensible (23) par l'intermédiaire du miroir tournant (22).

**Claims**

1. Marker for a high speed cinematographic camera comprising at least one light source (13) operating in pulse-like manner, electronic control means (14) for each source, enabling the latter to emit a light signal, said marker being characterized in that it also comprises means (15) for transmitting said light signal to a photosensitive surface (8, 23) with which the camera (5) is equipped, in that the source (13) operates in pulse-like manner and is a power laser diode and in that the electronic control means (14) incorporate means (26) for producing a given number of high intensity electric pulses, whereof the sum of the durations is at the most equal to the maximum duration of a light pulse which the laser diode (13) is able to emit.

2. Marker according to claim 1, characterized in that the camera being intended to film an event, the electronic control means (14) comprise :
means (25) for synchronizing the operation of the laser diode (13) with the start of the event,
an electric pulse generator (28),
a pulse counter (27) controlled by the synchronization means (25) dependent on the pulse generator (28) and controlling the same, in such a way that the pulse generator produces a given number of pulses, whereof the sum of the durations is at the most equal to the maximum duration of a light pulse which the laser diode (13) is able to emit and stops once this number has been produced, and
a power amplifier (29) for amplifying the pulses from the pulse generator (28), the amplified pulses being transmitted to the laser diode (13).

3. Marker according to claim 1, characterized in that the camera being intended to film an event, the electronic control means (14) comprise :
means (25) for synchronizing the operation of the laser diode (13) with the start of the event,
at least one regulatable monostable electric pulse generator ($37_1$ ... $37_N$), each monostable generator having input connected to the synchronization means (25), and being controlled so as to emit at a given moment, following the start of the event, an electric pulse of an appropriate duration and in such a way that the sum of the durations of the pulses emitted by the monostable generators is at the most equal to the maximum duration of a light pulse which the laser diode (13) is able to emit, and
a power amplifier (29) whose input is connected to the output of each monostable generator and whose output is connected to the laser diode (13).

4. Marker according to either of the claims 2 and 3, characterized in that the power amplifier (29) comprises HMOS or VMOS power transistors (31, 32) for amplifying the electric pulses received at its input.

5. Marker according to claim 4, characterized in that the power amplifier (29) successively comprises an impedance matching gain stage, a follower source impedance lowering stage and a current gain supply stage, the two latter stages being realized with the aid of said power transistors (31, 32).

6. Marker according to any one of the claims 1 to 5, characterized in that the camera (5) is an electronic camera provided with a slit (7) for defining the optical field of the camera and has a photosensitive surface (8) exposed to the field defined by the slit.

7. Marker according to claim 6, characterized in that the laser diode (13) is placed in the field defined by the slit (7) on the border thereof and in that the transmission means incorporate an optics (19) for focusing the light signal through the slit on to the photosensitive surface (8).

8. Marker according to claim 6, characterized in that the transmission means (15) incorporate an optical fibre (16), whereof one end (17) is optically coupled to the laser diode (13) and whereof the other end (18) is optically coupled to the photosensitive surface (8) at the border of the field defined by the slit (7).

9. Marker according to any one of the claims 1 to 5, characterized in that the camera (5) is a mechano-optical camera provided with a slit (20) for defining the optical field of the camera and in that the laser diode (13) is able to emit light belonging to the visible region of the electromagnetic spectrum.

10. Marker according to claim 9, characterized in that the camera (5) has a rotary mirror (22) able to reflect the image of the field defined by the slit (20) on to a photosensitive support (23), in that the laser diode (13) is placed in said field at the border thereof and that the transmission means (15) incorporate optics (24) for focusing the light signal on to the photosensitive support (23) via the rotary mirror (22).

**Patentansprüche**

1. Markierer für eine kinematografische Hochgeschwindigkeitskamera, enthaltend :
   wenigstens eine Lichtquelle (13), die impulsweise arbeitet, und
   elektronische Steuerungseinrichtungen (14) für jede Quelle, die es dieser erlauben, ein Lichtsignal abzugeben, dadurch gekennzeichnet, daß er weiterhin Einrichtungen (15) zur Übertragung des Lichtsignals auf eine fotoempfindliche Fläche (8, 23), mit der die Kamera (5) versehen ist, aufweist, und daß die im Impulsbetrieb arbeitende Quelle (13) eine Leistungslaserdiode ist, und daß die elektronischen Steuerungseinrichtungen (14) Einrichtungen (26) zum Erzeugen einer vorbestimmten Anzahl elektrischer Impulse Intensität enthalten, deren zeitdauersumme höchstens gleich der Maximaldauer eines Lichtimpulses ist, den die Laserdiode (13) abzugeben in der Lage ist.

2. Markierer nach Anspruch 1, dadurch gekennzeichnet, daß, bei zum Filmen eines Ereignisses bestimmter Kamera, die elektronischen Steuerungseinrichtungen (14) enthalten :
   Einrichtungen (25) für die Synchronisation der Funktion der Laserdiode (13) mit dem Anfang des Ereignisses,
   einen elektrischen Impulsgenerator (28),
   einen Impulszähler (27), der von den Synchronisationseinrichtungen (25) gesteuert wird, geregelt durch den Impulsgenerator (28) und diesen derart steuernd, daß der Impulsgenerator eine vorbestimmte Anzahl von Impulsen erzeugt, deren Zeitdauersumme höchstens gleich der Maximaldauer eines Lichtimpulses ist, den die Laserdiode abzugeben in der Lage ist, und der anschließend stehenbleibt, wenn diese Anzahl erzeugt ist, und
   einen Leistungsverstärker (29), um die von dem Impulsgenerator (28) erzeugten Impulse zu verstärken, wobei die verstärkten Impulse dann an die Laserdiode (13) übertragen werden.

3. Markierer nach Anspruch 1, dadurch gekennzeichnet, daß bei für das Filmen eines Ereignisses bestimmter Kamera die elektronischen Steuereinrichtungen (14) enthalten :
   Einrichtungen (25) zur Synchronisation der Funktion der Laserdiode (13) mit dem Beginn des Ereignisses,
   wenigstens einen elektrischen, monostabilen, regelbaren Impulsgenerator ($37_1$, ... $37_N$), wobei jeder monostabile Generator an seinem Eingang mit den Synchronisationseinrichtungen (25) verbunden ist und so geregelt ist, daß er zu einem vorbestimmten Augenblick nach dem Beginn des Ereignisses einen elektrischen Impuls geeigneter Dauer abgibt, und derart, daß die Zeitdauersumme der von den monostabilen Generatoren abgegebenen Impulse höchstens gleich der Maximaldauer eines Lichtimpulses ist, den die Laserdiode (13) abzugeben in der Lage ist, und
   einen Leistungsverstärker (29), dessen Eingang mit dem Ausgang eines jeden monostabilen Generators verbunden und dessen Ausgang mit der Laserdiode (13) verbunden ist.

4. Markierer nach einem der Ansprüche 2 und 3, dadurch gekennzeichnet, daß der Leistungsverstärker (29) Leistungstransistoren (31, 32) vom Typ HMOS oder VMOS enthält, um die an seinem Eingang empfangenen elektrischen Impulse zu verstärken.

5. Markierer nach Anspruch 4, dadurch gekennzeichnet, daß der Leistungsverstärker (29) aufeinanderfolgend eine Impedanzanpassungsverstärkerstufe, eine Impedanzabsenkstufe in Sourcefolgerschaltung und eine Stromverstärkerstufe enthält, wobei zwei letztgenannte Stufen mit Hilfe der genannten Leistungstransistoren (31, 32) realisiert sind.

6. Markierer nach einem der Ansprüche 1 bis 5, dadurch gekennzeichnet, daß die Kamera (5) eine elektronische Kamera ist, die mit einer Spaltblende (7) versehen ist, um das optische Feld der Kamera zu begrenzen, und die eine fotoempfindliche Oberfläche (8) aufweist, die dem durch die Spaltblende begrenzten Feld ausgesetzt ist.

7. Markierer nach Anspruch 6, dadurch gekennzeichnet, daß die Laserdiode (13) in dem Feld angeordnet ist, das durch die Spaltblende (7) begrenzt ist, am Rand des Feldes, und daß die Übertragungseinrichtungen (15) eine Optik (19) zur Fokussierung des durch die Spaltblende fallenden Lichtsignals auf die fotoempfindliche Oberfläche (8) aufweisen.

8. Markierer nach Anspruch 6, dadurch gekennzeichnet, daß die Übertragungseinrichtungen (15) eine optische Faser (16) enthalten, von der ein Ende (17) optisch mit der Laserdiode (13) gekoppelt ist und das andere Ende (18) optisch mit der fotoempfindlichen Oberfläche (8) am Rand des Feldes, das durch die Schlitzblende (7) begrenzt ist, gekoppelt ist.

9. Markierer nach einem der Ansprüche 1 bis 5, dadurch gekennzeichnet, dan die Kamera (5) eine optomechanische Kamera ist, die mit einer Schlitzblende (20) versehen ist, um das optische Feld der Kamera zu begrenzen, daß die Laserdiode (13) dazu eingerichtet ist, Licht abzugeben, das im sichtbaren Bereich des elektromagnetischen Spektrums erscheint.

10. Markierer nach Anspruch 9, dadurch gekennzeichnet, daß die Kamerea (5) einen Drehspiegel (22) enthält, der dazu geeignet ist, das Licht des durch die Schlitzblende (20) begrenzten Feldes auf einen fotoempfindlichen Träger (23) zu reflektieren, und daß die Laserdiode (13) in dem Feld am Rand derselben angeordnet ist, und daß die Übertragungseinrichtungen (15) eine Optik (24) zum Fokussieren des Lichtsignals auf den fotoempfindlichen Träger (23) mittels des Drehspiegels (22) aufweisen.

EP 0 147 259 B1

FIG. 1

FIG. 2

FIG. 3

FIG. 4

FIG. 5

FIG. 6

FIG. 7

EP 0 147 259 B1